(19) **Europäisches Patentamt**
**European Patent Office**
**Office européen des brevets**

(11) **EP 3 733 753 A1**

(12) **EUROPEAN PATENT APPLICATION**

(43) Date of publication:
**04.11.2020 Bulletin 2020/45**

(21) Application number: **19172431.9**

(22) Date of filing: **03.05.2019**

(51) Int Cl.:
*C08K 3/38* (2006.01)          *C08L 23/06* (2006.01)
*C08L 27/12* (2006.01)          *C08L 79/08* (2006.01)
*C08J 5/18* (2006.01)           *C08J 3/20* (2006.01)
*H05K 1/03* (2006.01)           *H01L 23/14* (2006.01)
*H01L 23/373* (2006.01)         *H01L 23/498* (2006.01)
*B29C 43/44* (2006.01)          *B29C 43/50* (2006.01)
*B29D 7/01* (2006.01)

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(71) Applicant: **3M Innovative Properties Company**
**Saint Paul, MN 55133-3427 (US)**

(72) Inventors:
• **Ruisinger, Bernd**
  **79104 Freiburg (DE)**
• **Kayser, Armin**
  **87730 Bad Grönenbach (DE)**

• **Muggli, Mark**
  **84547 Emmerting (DE)**
• **Dadalas, Michael**
  **84489 Burghausen (DE)**
• **Veenendaal, Robert**
  **6343 Klimmen (NL)**
• **Zimmermann-Ptacek, Johanna**
  **87561 Oberstdorf (DE)**

(74) Representative: **Mössner, Brigitte**
**3M Deutschland GmbH**
**Office of Intellectual Property Counsel**
**(PC 072P)**
**Carl-Schurz-Strasse 1**
**41453 Neuss (DE)**

(54) **FILM USABLE FOR ROLL-TO-ROLL PROCESSING OF FLEXIBLE ELECTRONIC DEVICES COMPRISING A COMPOSITE MATERIAL OF A POLYMER AND BORON NITRIDE**

(57)   The present disclosure relates to a film usable for roll-to-roll processing of flexible electronic devices, the film comprising a composite material comprising a polymer and hexagonal boron nitride particles, wherein the hexagonal boron nitride particles comprise platelet-shaped hexagonal boron nitride particles.
  The present disclosure further relates to a process for producing said film, and to the use of said film.

*FIG. 1*

*FIG. 2*

*FIG. 3A*

*FIG. 3B*

**Description**

Technical Field

The present disclosure relates to a film usable for roll-to-roll processing of flexible electronic devices, comprising a composite material of a polymer and hexagonal boron nitride particles.

Background

Polymer based films are used in many applications for reasons of electrical insulation, for example for flexible electronic devices such as printed circuit boards.

Flexible electronic devices can be produced by roll-to-roll processing which is a manufacturing technique of creating flexible electronic devices on a roll of flexible plastic foil. By this manufacturing technique, a polymer based film is transferred between two moving rolls of material. Roll-to-roll processing plays an increasingly important role in the high-throughput fabrication of flexible electronic devices. As used herein, films usable for roll-to-roll processing of flexible electronic devices may also be referred to as roll-to-roll films.

A major drawback of the polymer films is their low thermal conductivity, which leads to an undesired high temperature level of the electronic device, thus reducing its efficiency factor and lifetime.

To increase thermal conductivity of these films, thermally conductive fillers can be used such as hexagonal boron nitride. Hexagonal boron nitride is an electrically insulating and highly heat-conductive filler having a platelet-shaped particle morphology and highly anisotropic thermal conductivity properties.

When producing fluoropolymer roll-to-roll films filled with thermally conductive inorganic particles such as hexagonal boron nitride, a polymer fine powder can be dry blended with filler with help of a lubricant such as aliphatic hydrocarbons. WO2015029385 discloses another way of blending by co-agglomerating polymer microparticles and filler in an aqueous dispersion, separating the agglomerates from liquid and drying the agglomerates. After blending, the dry blended mixture or the mixed agglomerates are extruded into a profile and processed into a film using a calender, and the film is dried, stretched and sintered. When producing polyether ether ketone (PEEK) or polyethylene terephthalate (PET) roll-to-roll films, polymer granulate is processed by film extrusion. The molten polymer is pushed through a slot or die, followed by blow or cast extrusion. While for cast extrusion the polymer is extruded onto a polished chill roll, for blown film the polymer is extruded into a cylindrical die, inflated and formed into a bubble which then is cooled and collapsed. Additionally, a stretching step can be added. When producing polyimide roll-to-roll films an intermediate product of the polymerization process is casted onto a flat surface and polymerized by polycondensation at high temperatures. By the described production processes for roll-to-roll films, boron nitride platelets are oriented parallelly to the plane of the film, resulting in a high in-plane thermal conductivity and a low through-plane thermal conductivity.

US 2010/0200801 A1 discloses a thermal interface material comprising a base matrix comprising a polymer and 5 to 90 wt.% of boron nitride filler having a platelet structure, wherein the platelet structure of the boron nitride particles is substantially aligned for the thermal interface material to have a bulk thermal conductivity of at least 1 W/m*K. The thermal interface material is extruded into sheets. As a second step, the sheets may be stacked, pressed, cured and sliced in a direction perpendicular to the stacking direction, or the sheet may be compression rolled into a roll, cured and sliced into a plurality of circular pads in a direction perpendicular to the rolling direction. The method disclosed in US 2010/0200801 A1 does not allow to produce a roll-to-roll film, that is a film usable for roll-to-roll processing of flexible electronic devices.

US 2011/0223427 A1 discloses a method of producing a thermally conductive sheet comprising the steps of (i) preparing a plurality of sheet materials consisting essentially of a fluororesin containing polytetrafluoroethylene, thermally conductive inorganic particles, and a forming aid; (ii) stacking the plurality of sheet materials on one another and rolling the stacked sheet materials together; and (iii) removing the forming aid. The in-plane thermal conductivity of the sheet is higher than the through-plane thermal conductivity. Furthermore, the method disclosed in US 2011/0223427 A1 does not allow to produce a roll-to-roll film, that is a film usable for roll-to-roll processing of flexible electronic devices. US 2011/0192588 A1 discloses a heat conducting sheet comprising boron nitride platelets being oriented along the thickness direction of the sheet. The heat conducting sheet is manufactured by forming a primary sheet in which the boron nitride platelets are oriented substantially parallel to the main surfaces of the sheet. The primary sheet is laminated onto each other, thereby forming a formed body having a multilayered structure, and the formed body is sliced at an angle of 0 to 30 degrees to any normal line extending from main surfaces of the formed body. The method disclosed in US 2011/0192588 A1 does not allow to produce a roll-to-roll film, that is a film usable for roll-to-roll processing of flexible electronic devices.

Therefore, there is still a need for films usable for roll-to-roll processing of flexible electronic devices and having a high through-plane thermal conductivity.

As used herein, "a", "an", "the", "at least one" and "one or more" are used interchangeably. The term "comprise" shall include also the terms "consist essentially of" and "consists of".

Summary

In a first aspect, the present disclosure relates to a film usable for roll-to-roll processing of flexible electronic devices, the film comprising a composite material comprising a polymer and hexagonal boron nitride particles, wherein the hexagonal boron nitride particles comprise platelet-shaped hexagonal boron nitride particles, and wherein the platelet-shaped hexagonal boron nitride particles have a preferred orientation perpendicular to the direction of the plane of the film.
In another aspect, the present disclosure also relates to a process for producing a film as disclosed herein, the process comprising

   providing hexagonal boron nitride particles comprising platelet-shaped hexagonal boron nitride particles and a polymer,
   mixing the hexagonal boron nitride particles and the polymer, thereby obtaining a powder mixture,
   forming the powder mixture into a cylindrical shape, thereby obtaining a shaped cylindrical body having a central axis, wherein the platelet-shaped hexagonal boron nitride particles have a preferred orientation perpendicular to the central axis of the shaped cylindrical body,
   sintering the shaped cylindrical body, thereby obtaining a sintered body having a central axis, wherein the platelet-shaped hexagonal boron nitride particles have a preferred orientation perpendicular to the central axis of the sintered body, and
   rotating the sintered body around its central axis and skiving a film from the sintered body in radial direction.

In yet a further aspect, the present disclosure relates to the use of a film as disclosed herein for producing flexible electronic devices.
The film disclosed herein comprises highly oriented boron nitride platelet-shaped particles and has consequently highly anisotropic properties, particularly highly anisotropic thermal conductivity properties.
The film disclosed herein comprises boron nitride platelet-shaped particles oriented perpendicularly to the plane of the film and has a high through-plane thermal conductivity.
Boron nitride filled polymer films as disclosed herein allow to remove heat faster and more efficiently, due to the high through-plane thermal conductivity. Compared to other polymer films filled with boron nitride, the films disclosed herein have a higher through-plane thermal conductivity than in-plane thermal conductivity.
Films as disclosed herein can be used for roll-to-roll processing of flexible electronic devices.
In some embodiments, for example when polytetrafluoroethylene (PTFE) is used as polymer, the films can be used in applications where most conventional films such as polyethylene terephthalate (PET) cannot be used, due to the excellent thermal stability of PTFE.
Furthermore, the film disclosed herein has a low through-plane thermal expansion coefficient. The through-plane thermal expansion coefficient of the film is even lower than the in-plane thermal expansion coefficient. The low through-plane thermal expansion coefficient is especially important during manufacturing of printed circuit boards when using vertical interconnect access (VIA). Printed circuit boards (PCB) often fail due to the different expansion coefficient between the copper plating and the PCB substrate perpendicular to the plane of the film.
In addition, the film disclosed herein has low dielectric properties, specifically low permittivity and low loss factor, due to the use of boron nitride as thermally conductive filler.

Brief Description of the Drawings

The present disclosure is explained in more detail on the basis of the drawings, in which

   Figure 1 schematically shows the shaping of a cylindrical body by uniaxial pressing;

   Figure 2 schematically shows the skiving of a film as disclosed herein from the sintered cylindrical body; and

   Figures 3A and 3B show scanning electron micrographs of a cross-section of a film as disclosed herein.

Detailed Description

The film as disclosed herein is usable for roll-to-roll processing of flexible electronic devices, such as printed circuit boards. By roll-to-roll processing, a polymer based film is transferred between two moving rolls of material. For roll-to-roll processing, the film as disclosed herein is provided as a film wound up to a roll, and in roll-to-roll processing the film is transferred and wound up to another roll.

The film as disclosed herein comprises a composite material comprising hexagonal boron nitride particles. The hexagonal boron nitride particles comprise platelet-shaped hexagonal boron nitride particles. Platelet-shaped hexagonal boron nitride particles may also be referred to as flake-shaped or scale-like hexagonal boron nitride particles.

The platelet-shaped hexagonal boron nitride particles have a basal plane. The basal plane of the platelet-shaped hexagonal boron nitride particles is oriented perpendicularly to the direction of the plane of the film. In other words, in the film as disclosed herein, the platelet-shaped hexagonal boron nitride particles have a preferred orientation, the preferred orientation being perpendicular to the direction of the plane of the film.

The film as disclosed herein comprises a composite material comprising a polymer. The polymer may be a fluoropolymer or a polyimide or a polyester or ultra-high-molecular-weight polyethylene (UHMWPE).

The fluoropolymer used for the film may be selected from the group consisting of polytetrafluoroethylene (PTFE), perfluoroalkoxy alkanes (PFA) and fluorinated ethylene propylene (FEP). An example for a suitable polytetrafluoroethylene is TFM™, available from Dyneon GmbH, Burgkirchen, Germany. A polyester used for the film may be polyethylene terephthalate (PET).

The degree of orientation of the platelet-shaped hexagonal boron nitride particles in the film can be characterized by the texture index, measured on a film sample. The texture index of hexagonal boron nitride with isotropic orientation of the platelet-shaped hexagonal boron nitride particles, thus without preferred orientation, has a value of 1. For platelet-shaped hexagonal boron nitride particles being oriented parallelly to the plane of the film, the texture index increases with the degree of parallel orientation in the film sample and has values greater than 1. For platelet-shaped hexagonal boron nitride particles being oriented perpendicularly to the plane of the film, the texture index decreases with the degree of perpendicular orientation in the film sample and has values less than 1.

The texture index of the film as disclosed herein is at most 0.8. In some embodiments, the texture index of the film is at most 0.5. In some embodiments, the texture index of the film is at most 0.3. The texture index of the film is measured in a direction perpendicular to the plane of the film.

The texture index is determined by X-ray diffractometry. For this, the ratio of the intensities of the (002) and of the (100) reflection of hexagonal boron nitride (hBN) measured on X-ray diffraction diagrams of a film sample is determined and is divided by the corresponding ratio for an ideal, untextured hBN sample. This ideal ratio can be determined from the JCPDS data and is 7.29. The intensity of the (002) reflection is measured within a $2\Theta$ range from 25.8 to 27.6 degrees and that of the (100) reflection within a $2\Theta$ range from 41.0 to 42.2 degrees. The texture index (TI) can be determined from the formula:

$$TI = \frac{I_{(002),\,sample} / I_{(100),sample}}{I_{(002),\,theoretical} / I_{(100),\,theoretical}} = \frac{I_{(002),\,sample} / I_{(100),sample}}{7.29}$$

The intensity of the (100) reflection should be at least 1.0. If the intensity of the (100) reflection is below 1.0, the measurement speed in the $2\Theta$ ranges from 25.8 to 27.6 degrees and from 41.0 to 42.2 degrees can be decreased to obtain a sufficient intensity of the (100) reflection.

The mean particle size ($d_{50}$) of the hexagonal boron nitride particles used for the film disclosed herein may be from 0.5 to 100 $\mu$m. Preferably, the mean particle size ($d_{50}$) of the hexagonal boron nitride particles is at least 5 $\mu$m, more preferably at least 10 $\mu$m. In some embodiments, the mean particle size ($d_{50}$) is from 5 to 50 $\mu$m or from 5 to 30 $\mu$m. The mean particle size ($d_{50}$) can be measured by laser diffraction.

The mean aspect ratio of the platelet-shaped hexagonal boron nitride particles typically is at least 5. The aspect ratio is the ratio of the diameter to the thickness of the platelet-shaped hexagonal boron nitride particles. As used herein, the platelet-shaped hexagonal boron nitride particles are also referred to as boron nitride platelets. The aspect ratio of the boron nitride platelets may be at least 10, or at least 15, or at least 20. The mean aspect ratio of the boron nitride platelets may also be up to 40, or up to 100. The mean aspect ratio of the boron nitride platelets may be from 7 to 20, or from 20 to 40, or from 7 to 40, or from 10 to 40, or from 50 to 100. Typically, the mean aspect ratio of the boron nitride platelets is at most 500. The mean aspect ratio can be measured by scanning electron microscopy (SEM), by determining the aspect ratio of 20 particles, and calculating the mean value of the 20 individual values determined for the aspect ratio. The aspect ratio of an individual boron nitride platelet is determined by measuring the diameter and the thickness of the boron nitride platelet and calculating the ratio of the diameter to the thickness. Required magnification of the SEM images used to measure diameter and thickness of boron nitride platelets depends on the size of the platelets. Magnification should be at least 1000x, preferably at least 2000x. Where appropriate, i.e. for smaller platelets with a mean particle size ($d_{50}$) of 5 to 10 $\mu$m, a magnification of 5000x should be used.

A portion of the hexagonal boron nitride platelets may be agglomerated to form boron nitride agglomerates.

The mean particle size ($d_{50}$) of the boron nitride agglomerates may be at most 500 μm and more specifically at most 250 μm, at most 150 μm or at most 100 μm. The mean particle size ($d_{50}$) of the boron nitride agglomerates may be at least 30 μm or at least 50 μm. The mean particle size ($d_{50}$) can be measured by laser diffraction. Also mixtures of agglomerates and non-agglomerated primary particles may be used. The boron nitride agglomerates may be spherical, irregularly shaped or flake-shaped. The flake-shaped agglomerates may have an aspect ratio of from 1 to 20.

The composite material may comprise from 10 to 60 percent by volume of hexagonal boron nitride particles, based on the total amount of the composite material. In some embodiments, the composite material comprises from 20 to 50 percent by volume of hexagonal boron nitride particles, based on the total amount of the composite material.

In some embodiments, all hexagonal boron nitride particles are platelet-shaped. In some embodiments, all hexagonal boron nitride particles are non-agglomerated.

The thickness of the film disclosed herein may be from 0.010 mm to 6 mm. Preferably, the film thickness is from 50 to 500 μm. The size of the hexagonal boron nitride particles may be selected depending on the film thickness.

The through-plane thermal conductivity of the film disclosed herein is at least 0.7 W/m*K. In some embodiments, the through-plane thermal conductivity of the film is at least 1 W/m*K, or at least 2 W/m*K, or at least 5 W/m*K.

The in-plane thermal conductivity of the film disclosed herein is at least 0.4 W/m*K. In some embodiments, the in-plane thermal conductivity of the film is at least 0.7 W/m*K, or at least 1 W/m*K, or at least 2 W/m*K.

For films used for the production of flexible electronic devices such as printed circuit boards, a high through-plane thermal conductivity is desired, whereas the in-plane thermal conductivity should also be as high as possible.

The through-plane thermal conductivity and the in-plane thermal conductivity can be measured on samples cut from a sintered body from which the film is skived.

Surprisingly, the through-plane thermal conductivity of the film disclosed herein is higher than the in-plane thermal conductivity of the film. Typically, the ratio of the through-plane thermal conductivity to the in-plane thermal conductivity is from 1.4 to 4.0. In some embodiments, the ratio of the through-plane thermal conductivity to the in-plane thermal conductivity is from 2.0 to 3.5.

The through-plane thermal expansion coefficient of the film disclosed herein is lower than the in-plane thermal expansion coefficient of the film. The through-plane thermal expansion coefficient and the in-plane thermal expansion coefficient may be measured in the temperature range from 100 to 200 °C. Typically, the through-plane thermal expansion coefficient is lower than $130 * 10^{-6}$ $K^{-1}$, measured in a temperature range from 100 °C to 200 °C. In some embodiments, the through-plane thermal expansion coefficient is lower than $50 * 10^{-6}$ $K^{-1}$, measured in a temperature range from 100 °C to 200 °C. The in-plane thermal expansion coefficient typically is lower than $200 * 10^{-6}$ $K^{-1}$. Typically, the ratio of the through-plane thermal expansion coefficient to the in-plane thermal expansion coefficient is from 0.9 to 0.2, the through-plane thermal expansion coefficient and the in-plane thermal expansion coefficient being measured in the temperature range from 100 to 200 °C. In some embodiments, the ratio of the through-plane thermal expansion to the in-plane thermal expansion is from 0.7 to 0.2, the through-plane thermal expansion coefficient and the in-plane thermal expansion coefficient being measured in the temperature range from 100 to 200 °C.

The through-plane thermal expansion of the film disclosed herein is lower than the through-plane thermal expansion of a polymer film produced without filler particles.

The composite material may further comprise fillers for improvement of the mechanical properties, such as glass fibers or carbon fibers, and further thermal conductive fillers, such as alumina or graphite. The composite material may further comprise hollow glass microspheres for achieving even lower dielectric properties or for further lowering coefficient of thermal expansion.

The film as disclosed herein may be metallized or surface-treated. Suitable surface treatments are plasma treatments and etching processes, for example with sodium naphthalene.

The film as disclosed herein can be produced by a process comprising

providing hexagonal boron nitride particles comprising platelet-shaped hexagonal boron nitride particles and a polymer,

mixing the hexagonal boron nitride particles and the polymer, thereby obtaining a powder mixture,

forming the powder mixture into a cylindrical shape, thereby obtaining a shaped cylindrical body having a central axis, wherein the platelet-shaped hexagonal boron nitride particles have a preferred orientation perpendicular to the central axis of the shaped cylindrical body,

sintering the shaped cylindrical body, thereby obtaining a sintered body having a central axis, wherein the platelet-shaped hexagonal boron nitride particles have a preferred orientation perpendicular to the central axis of the sintered body, and

rotating the sintered body around its central axis and skiving a film from the sintered body in radial direction.

For producing the film as disclosed herein, hexagonal boron nitride particles comprising boron nitride platelets and a polymer as described above more in detail may be used.

The hexagonal boron nitride particles used for producing the film as disclosed herein have a specific surface area (BET) of at most 20 m$^2$/g, preferably at most 10 m$^2$/g. In some embodiments, the specific surface area of the hexagonal boron nitride particles is at most 5 m$^2$/g. Typically, the specific surface area of the hexagonal boron nitride particles is at least 1 m$^2$/g.

The hexagonal boron nitride particles and the polymer may be mixed using conventional mixing aggregates such as intensive mixers or ploughshare mixers.

The obtained powder mixture is formed into a cylindrical shape, resulting in a shaped cylindrical body having a central axis. In the shaped cylindrical body, the platelet-shaped hexagonal boron nitride particles have a preferred orientation perpendicular to the central axis of the shaped cylindrical body.

The forming of the powder mixture into a cylindrical shape may be carried out by pressing, preferably by uniaxial pressing. The applied pressure may be from 15 MPa to 90 MPa. Pressing may be carried out at room temperature (20 °C), or at higher temperatures up to the sintering temperature.

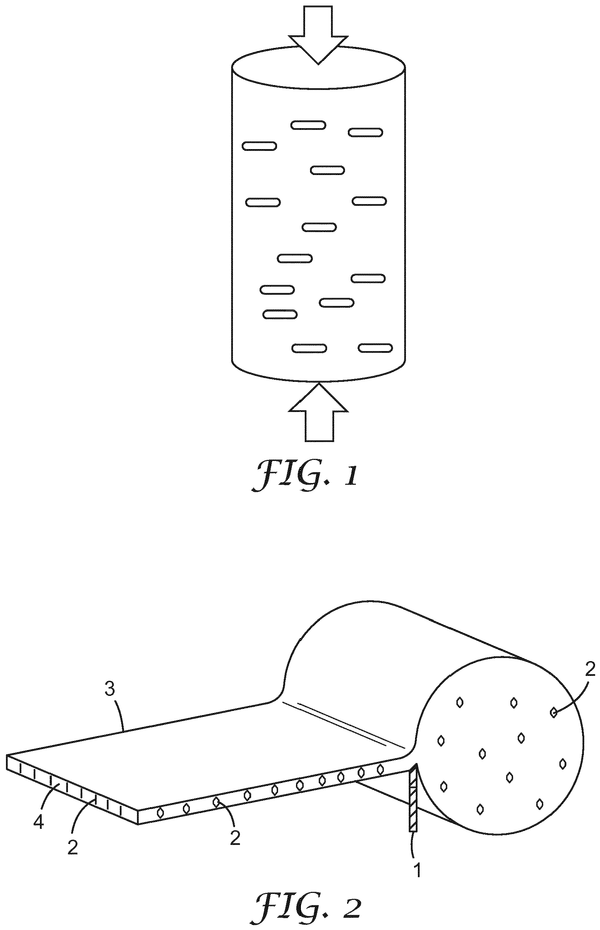

In Figure 1, the shaping of the cylindrical body by uniaxial pressing is represented schematically. The arrows indicate the uniaxial pressing of the powder mixture. After pressing, platelet-shaped hexagonal boron nitride particles are oriented perpendicular to the central axis of the shaped cylindrical body.

After forming, the shaped cylindrical body is sintered, whereby a sintered body having a central axis is obtained. In the sintered body, the platelet-shaped hexagonal boron nitride particles have a preferred orientation perpendicular to the central axis of the sintered body.

The sintering of the shaped cylindrical body may be carried out at a temperature of from 135 °C to 430 °C, depending on the polymer system. For polytetrafluoroetylene, the sintering of the shaped cylindrical body may be carried out at a temperature of from 327 °C to 430 °C, preferably from 365 °C to 390 °C. For polyethyleneterephthalate, the sintering of the shaped cylindrical body may be carried out at a temperature of about 260 °C or of from 250 °C to 270 °C. For polyimide, the sintering may be carried out at a temperature above 350 °C and up to 380 °C. For ultra-high-molecular-weight polyethylene (UHMWPE), the sintering may be carried out at a temperature of 135 °C to 138 °C.

The sintered body has a density of at least 80% of theoretical density, preferably of at least 90% of theoretical density. The density can be determined by using the Archimedes method. The theoretical density of the sintered body is calculated from the powder density of hexagonal boron nitride which is 2.27 g/cm$^3$, the density of the respective polymer and from the fractions of hexagonal boron nitride and the polymer in the composition of the sintered body.

The sintered body produced by the process as disclosed herein is made of a composite material comprising a polymer and hexagonal boron nitride particles, the hexagonal boron nitride particles comprising platelet-shaped hexagonal boron nitride particles. The platelet-shaped hexagonal boron nitride particles have a preferred orientation perpendicular to the central axis of the sintered body.

After sintering, the sintered body is rotated around its central axis and a film is skived from the sintered body in radial direction. In the skiving step, the boron nitride platelets maintain their orientation. Therefore, the boron nitride platelets have a preferred orientation in the film disclosed herein perpendicular to the direction of the plane of the film. The preferred orientation can be measured by the texture index which has values below 1.

Figure 2 schematically shows the skiving of the film from the sintered cylindrical body. The sintered cylindrical body comprises platelet-shaped hexagonal boron nitride particles (2) having a preferred orientation perpendicular to the central axis of the sintered body, i.e. the basal plane of the platelet-shaped hexagonal boron nitride particles is oriented perpendicularly to the central axis of the sintered body. For skiving, a skiving blade (1) is used.

Figure 2 also shows a film (3) as disclosed herein, after skiving. The film comprises platelet-shaped hexagonal boron nitride particles (2) having a preferred orientation perpendicular to the direction of the plane of the film, i.e. the basal plane of the platelet-shaped hexagonal boron nitride particles is oriented perpendicularly to the direction of the plane of the film. A cross-sectional view (4) of the film is also shown in Figure 2.

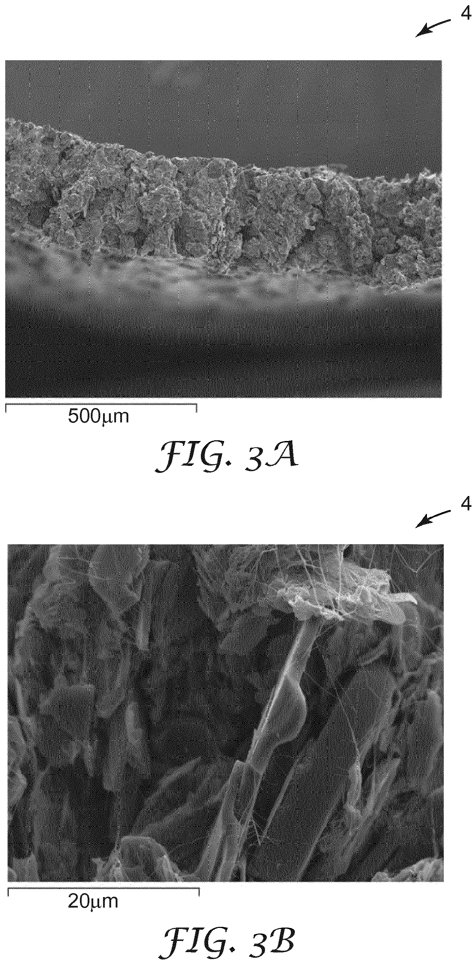

Figures 3A and 3B show scanning electron micrographs (SEM) of a cross-section (4) of the skived film as disclosed herein. Figure 3A has a magnification of 20x, Figure 3B has a magnification of 500x. The orientation of the section of Figure 3B is the same as the orientation of the film section of Figure 3A. Figure 3B shows platelet-shaped hexagonal boron nitride particles in the film with an orientation perpendicular to the direction of the plane.

The film as disclosed herein can be used for producing flexible electronic devices, specifically printed circuit boards (PCB).

The film as disclosed herein can also be used for producing non-flexible electronic devices, specifically non-flexible printed circuit boards (PCB), by laminating several layers of flexible film.

The film as disclosed herein may be used for electrical insulation of electromotors and for cable insulation, and for all applications that require a high through-plane thermal conductivity of the film.

If no additional fillers are used that have electrically conductive properties such as graphite, the film as disclosed herein has electrically insulating properties and can be used for all applications that require a high through-plane thermal conductivity in combination with electrically insulating properties.

Examples

Example 1 (EX1)

25 kg of a mixture of polytetrafluoroethylene (PTFE) powder grade TF 1750 (available from Dyneon GmbH, Burgkirchen, Germany) and hexagonal boron nitride particles (Cooling Filler Platelets CFP015, available from 3M Technical Ceramics, Zweigniederlassung der 3M Deutschland GmbH, Kempten, Germany) were prepared, with 10% by volume of boron nitride powder and 90% by volume of PTFE. The CFP015 particles comprise platelet-shaped hexagonal boron nitride particles. The specific surface area (BET) of the CFP015 particles is 2.4 $m^2/g$, the mean particle size ($d_{50}$) is 14.5 $\mu$m and the aspect ratio is 31.

The mixing was carried out in an Eirich mixer for 2.5 min at 300 rpm. The temperature during mixing was kept below 21 °C.

Then, 1.5 kg of the powder mixture was placed into a cylindrical pressing mold and the material was uniaxially pressed in a direction parallel to the central axis of the pressing mold, at a pressure of 50 MPa and a temperature of 23 °C. In the obtained formed block, the boron nitride platelets have a preferred orientation perpendicular to the pressing direction, i.e. perpendicular to the central axis of the cylindrical formed block.

Sintering of the obtained formed BN/PTFE block was carried out at a temperature of 387 °C in air. The sintered block had a diameter of 95 mm and a height of 100 mm. The density of the sintered block was 2.18 $g/cm^3$ corresponding to 96.6% of theoretical density.

After sintering, the block was fixed in a turning lathe. A blade was placed at a distance corresponding to the desired thickness of the film. By rotating the block, a film was skived in radial direction from the block.

For measuring thermal conductivity, the laser-flash method is used and carried out with the Nanoflash LFA 447 (Netzsch, Selb, Germany) according to ISO 22007-4:2017. Measurements are taken at 25 °C. Thermal conductivity (TC) is determined by measuring the values for thermal diffusivity a, specific thermal capacity $c_p$ and density D, and is calculated from these values according to the equation

$$TC = a * c_p * D.$$

The thermal diffusivity a and the thermal capacity $c_p$ are measured using a Nanoflash LFA 447 (Netzsch, Selb, Germany) on samples having the dimensions 10 x 10 x 2 $mm^3$. Samples were prepared by cutting cuboids 10 x 10 x 15 $mm^3$, one in a direction parallel and one in a direction perpendicular to the central axis of the cylindrical formed block. The cuboid was then cut into 3 samples for thermal conductivity measurement, having the dimensions 10 x 10 x 2 $mm^3$. Density is calculated by weighing and determining the geometrical dimensions of the precisely shaped samples. The standard Pyroceram 9606 is used for calibration of the measurement.

The coefficient of thermal expansion (CTE) was measured using a thermomechanical analyzer (TMA 2940, TA Instruments), applying a heating rate of 5°/min. The CTE was determined from the slope of the curve of thermal expansion versus temperature between 100 and 200 °C. To determine directional dependence, cylindrical specimens with a diameter of 5 mm and a height of 8 mm were prepared, one in a direction parallel and one in a direction perpendicular to the central axis of the cylindrical formed block.

For measuring of the texture index, films with a size of 1.5 x 1.5 cm were fixed on a silicon single crystal with a diameter of 24.5 mm, and the XRD measurement was carried out as described above.

The test results are shown in Table 1.

Table 1:

| | Filler content [vol.%] | Filler $d_{50}$ [$\mu$m] | TP-TC [W/m*K] | IP-TC [W/m*K] | Ratio TP-TC/ IP-TC | TP-CTE [$10^{-6}$ $K^{-1}$] | IP-CTE [$10^{-6}$ $K^{-1}$] | Texture Index |
|---|---|---|---|---|---|---|---|---|
| CEX | 0 | - | 0.28 | 0.28 | 1 | 145 | 145 | - |
| EX1 | 10 | 14.5 | 0.69 | 0.45 | 1.5 | 128 | 155 | 0.71 |
| EX2 | 30 | 14.5 | 3.33 | 1.48 | 2.3 | 77 | 151 | 0.30 |
| EX3 | 50 | 14.5 | 8.10 | 2.98 | 2.7 | 39 | 111 | 0.20 |
| EX4 | 10 | 7.9 | 0.76 | 0.52 | 1.5 | 122 | 164 | 0.60 |
| EX5 | 30 | 7.9 | 3.87 | 1.70 | 2.3 | 72 | 157 | 0.25 |

(continued)

| | Filler content [vol.%] | Filler $d_{50}$ [μm] | TP-TC [W/m*K] | IP-TC [W/m*K] | Ratio TP-TC/ IP-TC | TP-CTE [$10^{-6}$ K$^{-1}$] | IP-CTE [$10^{-6}$ K$^{-1}$] | Texture Index |
|---|---|---|---|---|---|---|---|---|
| EX6 | 50 | 7.9 | 7.2 | 2.51 | 2.9 | 40 | 119 | 0.20 |
| TP-TC: through-plane thermal conductivity IP-TC: in-plane thermal conductivity TP-CTE: through-plane coefficient of thermal expansion 100 - 200 °C IP-CTE: in-plane coefficient of thermal expansion 100 - 200 °C | | | | | | | | |

Example 2 (EX2)

Example 1 was repeated, with the exception that 30% by volume of boron nitride powder and 70% by volume of PTFE were used. The density of the sintered block was 2.17 g/cm$^3$ corresponding to 95.9% of theoretical density.
The test results are shown in Table 1.

Example 3 (EX3)

Example 1 was repeated, with the exception that 50% by volume of boron nitride powder and 50% by volume of PTFE were used. The density of the sintered block was 2.00 g/cm$^3$ corresponding to 88.5% of theoretical density.
The test results are shown in Table 1.

Examples 4 to 6 (EX4 to EX6))

Examples 1 to 3 were repeated, with the exception that Cooling Filler Platelets CFP0075 (available from 3M Technical Ceramics, Zweigniederlassung der 3M Deutschland GmbH, Kempten, Germany) were used as hexagonal boron nitride particles. The CFP0075 particles comprise platelet-shaped hexagonal boron nitride particles. The specific surface area (BET) of the CFP0075 particles is 5.6 m$^2$/g, the mean particle size ($d_{50}$) is 7.9 μm and the aspect ratio is 17.
The density of the sintered block was 2.15 g/cm$^3$ corresponding to 94.9% of theoretical density for Example 4; 2.16 g/cm$^3$ corresponding to 95.3% of theoretical density for Example 5; and 1.94 g/cm$^3$ corresponding to 85.4% of theoretical density for Example 6.
The test results are shown in Table 1.

Comparative Example (CEX)

Example 1 was repeated, with the exception that no boron nitride particles were added to the PTFE powder and a sample of 100% by volume of PTFE was pressed and sintered as described in Example 1.
The density of the sintered block was 2.16 g/cm$^3$.
The test results are shown in Table 1.
The examples show that the platelet-shaped hexagonal boron nitride particles are aligned in the film disclosed herein perpendicular to the film direction, resulting in a high through-plane thermal conductivity.

**Claims**

1. A film usable for roll-to-roll processing of flexible electronic devices, the film comprising a composite material comprising a polymer and hexagonal boron nitride particles, wherein the hexagonal boron nitride particles comprise platelet-shaped hexagonal boron nitride particles, and wherein the platelet-shaped hexagonal boron nitride particles have a preferred orientation, and wherein the preferred orientation is perpendicular to the direction of the plane of the film.

2. The film according to claim 1, wherein the polymer is a fluoropolymer or a polyimide or a polyester or ultra-high-molecular-weight polyethylene (UHMWPE).

3. The film according to claim 1 or 2, wherein the polymer is a fluoropolymer, and wherein the fluoropolymer is selected from the group consisting of polytetrafluoroethylene (PTFE), perfluoroalkoxy alkanes (PFA) and fluorinated ethylene propylene (FEP).

4. The film according to any one of claims 1 to 3, wherein the texture index of the film is at most 0.8, and wherein the texture index is measured in a direction perpendicular to the plane of the film.

5. The film according to any one of claims 1 to 4, wherein the mean particle size ($d_{50}$) of the hexagonal boron nitride particles is from 0.5 to 100 $\mu$m.

6. The film according to any one of claims 1 to 5, wherein the aspect ratio of the platelet-shaped hexagonal boron nitride particles is at least 5.

7. The film according to any one of claims 1 to 6, wherein the composite material comprises from 10 to 60 percent by volume of hexagonal boron nitride particles, based on the total amount of the composite material.

8. The film according to any one of claims 1 to 7, wherein the thickness of the film is from 0.010 mm to 6 mm.

9. The film according to any one of claims 1 to 8, wherein the through-plane thermal conductivity of the film is at least 0.7 W/m*K, and wherein the in-plane thermal conductivity of the film is at least 0.4 W/m*K.

10. The film according to any one of claims 1 to 9, wherein the through-plane thermal conductivity of the film is higher than the in-plane thermal conductivity of the film, and wherein the ratio of the through-plane thermal conductivity to the in-plane thermal conductivity is from 1.4 to 4.0.

11. The film according to any one of claims 1 to 10, wherein the through-plane thermal expansion coefficient of the film is lower than the in-plane thermal expansion coefficient of the film, and wherein the through-plane thermal expansion coefficient and in-plane thermal expansion coefficient are measured in the temperature range from 100 to 200 °C, and wherein the ratio of the through-plane thermal expansion coefficient to the in-plane thermal expansion coefficient is from 0.9 to 0.2.

12. A process for producing a film according to claim 1, the process comprising
providing hexagonal boron nitride particles comprising platelet-shaped hexagonal boron nitride particles and a polymer,
mixing the hexagonal boron nitride particles and the polymer, thereby obtaining a powder mixture,
forming the powder mixture into a cylindrical shape, thereby obtaining a shaped cylindrical body having a central axis, wherein the platelet-shaped hexagonal boron nitride particles have a preferred orientation perpendicular to the central axis of the shaped cylindrical body,
sintering the shaped cylindrical body, thereby obtaining a sintered body having a central axis, wherein the platelet-shaped hexagonal boron nitride particles have a preferred orientation perpendicular to the central axis of the sintered body, and
rotating the sintered body around its central axis and skiving a film from the sintered body in radial direction.

13. The process according to claim 12, wherein the forming of the powder mixture into a cylindrical shape is carried out by pressing, preferably by uniaxial pressing, at a pressure of from 15 MPa to 90 MPa, and wherein the sintering of the shaped cylindrical body is carried out at a temperature of from 130 °C to 430 °C.

14. The process according to claim 12 or 13, wherein the hexagonal boron nitride particles have a specific surface area (BET) of at most 20 $m^2$/g.

15. Use of a film according to any of claims 1 to 11 for producing flexible electronic devices.

*FIG. 1*

*FIG. 2*

4

500μm

*FIG. 3A*

4

20μm

*FIG. 3B*

Europäisches
Patentamt

European
Patent Office

Office européen
des brevets

# EUROPEAN SEARCH REPORT

Application Number

EP 19 17 2431

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | WO 2008/085999 A1 (MOMENTIVE PERFORMANCE MAT INC [US]; RAMASAMY RAMAMOORTHY [US] ET AL.) 17 July 2008 (2008-07-17) | 1-12,15 | INV.<br>C08K3/38<br>C08L23/06 |
| Y | * page 2, paragraph 7; claims 1,3 *<br>* page 3, paragraph 11; figure 3 *<br>* page 4, paragraph 17-19 *<br>* page 8, paragraph 28-30; claims 11,15 *<br>* page 9 - page 10; examples A,B; table 1 *<br>* page 3, paragraphs 15,16 - page 4; claims 4,8 * | 13,14 | C08L27/12<br>C08L79/08<br>C08J5/18<br>C08J3/20<br>H05K1/03<br>H01L23/14<br>H01L23/373<br>H01L23/498<br>B29C43/44<br>B29C43/50<br>B29D7/01 |
| X | CHEN PAN ET AL: "Investigation of the through-plane thermal conductivity of polymer composites with in-plane oriented hexagonal boron nitride",<br>INTERNATIONAL JOURNAL OF HEAT AND MASS TRANSFER.,<br>vol. 120, 9 December 2017 (2017-12-09), pages 1-8, XP055633054,<br>GB<br>ISSN: 0017-9310, DOI:<br>10.1016/j.ijheatmasstransfer.2017.12.015 | 12 | |
| Y | * the whole document * | 13,14 | TECHNICAL FIELDS SEARCHED (IPC)<br><br>C08K<br>C08J<br>C08L<br>H05K<br>B29D<br>B29C |
| A | MIZUKA TANIMOTO ET AL: "Anisotropic Thermal Diffusivity of Hexagonal Boron Nitride-Filled Polyimide Films: Effects of Filler Particle Size, Aggregation, Orientation, and Polymer Chain Rigidity",<br>ACS APPLIED MATERIALS & INTERFACES,<br>vol. 5, no. 10, 9 May 2013 (2013-05-09), pages 4374-4382, XP055633318,<br>US<br>ISSN: 1944-8244, DOI: 10.1021/am400615z<br>* the whole document * | 1-15 | |

-/--

The present search report has been drawn up for all claims

| Place of search | Date of completion of the search | Examiner |
|---|---|---|
| Munich | 25 October 2019 | Schlembach, Sandra |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

Europäisches
Patentamt

European
Patent Office

Office européen
des brevets

# EUROPEAN SEARCH REPORT

Application Number

EP 19 17 2431

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | Ralf Damasch: "417 5.4 Bornitrid als multifunktioneller F?llstoff in Polymersystemen", <br><br> 7 May 2007 (2007-05-07), XP055109849, Retrieved from the Internet: URL:http://www.keramverband.de/keramik/pdf/07/sem07-13.pdf [retrieved on 2014-03-25] * the whole document * | 1-15 | |
| A | "Powder Coating and Films" In: Laurence W. Mc Keen: "Fluorinated Coatings and Finishes Handbook: The Definitive User`s Guide", 11 October 2015 (2015-10-11), William Andrew Inc. (Mathew Deans), Oxford, XP002795150, ISBN: 978-0-323-37126-1 vol. 2, page 204, DOI: http://dx.doi.org/10.1016/B978-0-323-37126-1.00001-1, * page 204 * | 12 | |

TECHNICAL FIELDS SEARCHED (IPC)

The present search report has been drawn up for all claims

| Place of search | Date of completion of the search | Examiner |
|---|---|---|
| Munich | 25 October 2019 | Schlembach, Sandra |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 19 17 2431

This annex lists the patent family members relating to the patent documents cited in the above-mentioned European search report.
The members are as contained in the European Patent Office EDP file on
The European Patent Office is in no way liable for these particulars which are merely given for the purpose of information.

25-10-2019

| Patent document cited in search report | Publication date | Patent family member(s) | Publication date |
|---|---|---|---|
| WO 2008085999 A1 | 17-07-2008 | EP 2118191 A1 | 18-11-2009 |
| | | JP 5608371 B2 | 15-10-2014 |
| | | JP 2010515807 A | 13-05-2010 |
| | | US 2010200801 A1 | 12-08-2010 |
| | | WO 2008085999 A1 | 17-07-2008 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2015029385 A
- US 20100200801 A1
- US 20110223427 A1
- US 20110192588 A1